# EUROPÄISCHE PATENTSCHRIFT

(11) **EP 2 096 723 B1**
(45) Veröffentlichungstag und Bekanntmachung des Hinweises auf die Patenterteilung: **05.06.2013**
(21) Anmeldenummer: 09001683.3
(22) Anmeldetag: 06.02.2009
(51) Int. Cl.: H01R 13/66, H01R 25/00

(54) **Stromverteilerleiste**
Current distribution rail
Réglette de distribution de courant

(30) Priorität: 29.02.2008 DE 202008002882 U
(43) Veröffentlichungstag der Anmeldung: 02.09.2009
(73) Patentinhaber: Knürr GmbH, 94424 Arnstorf (DE)
(72) Erfinder: Huber, Arthur, 94081 Fürstenzell (DE); Hofbauer, Thomas, 94113 Tiefenbach (DE); Feigl, Josef, 94424 Arnstorf (DE); Mees, Ronny, 94474 Vilshofen (DE)
(74) Vertreter: Heim, Hans-Karl

(56) Entgegenhaltungen:
- CN-Y- 2 816 996
- US-A- 5 650 771
- US-B1- 6 295 003
- US-B1- 6 476 729

## Beschreibung

Die Erfindung betrifft eine Stromverteilerleiste gemäß Oberbegriff des Anspruches 1.

Stromverteilerleisten dieser Art werden teilweise auch als Steckdosenleisten bezeichnet. In ihrer Funktion als Stromverteilerleiste finden diese Einrichtungen insbesondere Verwendung in EDV-Schränken, die mit einer Vielzahl von unterschiedlichen Elektronikkomponenten, z.B. Servern, Ventilatoreinheiten etc. ausgestattet sind.

Ein Problem das sich hierbei stellt, ist die genaue Überwachung der Ströme bzw. Leistungen, die die einzelnen Verbraucher insgesamt über die Stromverteilerleiste ziehen.

Dieser Aspekt ist sowohl bei einphasigen Stromverteilerleisten wie auch bei mehrphasigen, insbesondere dreiphasigen, Stromverteilerleisten zu beachten.

Aus US 6,476,729 B1 ist eine Stromverteilerleiste mit mehreren Steckdosen bekannt. Die Stromverteilerleiste weist ein Messmodul mit einer Anzeige auf.

Gegenstand von CN 2 816 996 Y ist ein Messgerät mit einem Bildschirm, der über ein Scharnier mit einem Hauptkörper des Messgeräts verbunden und so relativ zu diesem drehbar ist.

Der Erfindung liegt daher die Aufgabe zugrunde, eine Stromverteilerleiste mit einer optimalen Überwachung der darüber zur Verteilung kommenden Ströme so auszulegen, dass einerseits unterschiedliche Belastungen erkannt werden und andererseits auch im Hinblick auf unterschiedliche Anordnungsmöglichkeiten und Ausrichtungen der Stromverteilerleiste, eine gute Erkennbarkeit in einem entsprechenden Display eines Amperemeter erzielt wird.

Diese **Aufgabe** wird erfindungsgemäß durch die Merkmale des Anspruches 1 gelöst.

Ein Kerngedanke ist hierbei, das dem Verbraucheranschluss zugeordnete und insbesondere vorgeschaltete Amperemeter zur Messung und Anzeige der Echteffektivwerte (TRMS) des Stromes auszulegen und dies sowohl für einphasige wie dreiphasige Ausführung. Desweiteren ist im Hinblick auf flexible Anordnungsmöglichkeiten der Stromverteilerleiste, z.B. in vertikaler oder horizontaler Ausrichtung, die Anzeige des Amperemeters in Winkelschritten verstellbar, was über einen Taster erfolgt.

Die Verstellbarkeit bzw. Drehbarkeit der Anzeige, eine digitale LCD-Anzeige ist, erfolgt hierbei über einen Kurzhub-Taster. Die Drehbarkeit der Anzeige wird zweckmäßiger Weise in 90°-Schritten realisiert, so dass die direkte Wertanzeige im Display in dem Winkel 0°, 90°, 180° und 270° angezeigt werden kann. Bevorzugter Weise werden bei 3 Phasen alle Phasen immer angezeigt. Der Taster und Schalter dient primär zur Einstellung und Schaltung des gewünschten Winkels der LCD-Anzeige und auch zur Änderung des Hintergrundes der Anzeige.

Die Anzeige des Amperemeters kann aber auch so ausgelegt sein, dass die komplette Anzeige über alle Phasen im Display oder auch durchschaltbar jede einzelne Phase dargestellt werden kann.

Die eingesetzte LCD-Anzeige kann je nach Anwendungsbereich einen dunklen oder weißen bzw. hellen Hintergrund aufweisen. Desweiteren ist bei Nichtbedarf der Stromanzeige über eine Sparschaltung eine Reduzierung der Hintergrundbeleuchtung, z.B. nach 90 Minuten, durchführbar, wodurch eine Erhöhung der Lebensdauer erreicht wird.

Zur weiteren Verbesserung der Überwachung ist das Amperemeter auch so ausgelegt, dass eine Änderung bzw. Differenz der Phasenströme um einen bestimmten Prozentsatz oder Betrag, z.B. von 5%, die Anzeige für die jeweilige Phase blinken lässt.

Auch ist zweckmäßiger Weise vorgesehen, dass bei unterschiedlicher Belastung der Phasen und Überschreiten eines Grenzwertes sozusagen eine Schieflastwarnung angezeigt wird.

Die Stromverteilerleiste kann einphasig oder dreiphasig für unterschiedliche Ströme ausgelegt sein, beispielsweise eine einphasige oder dreiphasige Auslegung bis 16 A. Auch Auslegungen bis 50 A sind möglich.

Die Anzeige des Echteffektivwertes (TRMS, True Root Mean Square) von Wechselstromgrößen ermöglicht es daher, die tatsächliche Stromaufnahme des jeweiligen Verteilers genau kontrollieren zu können. Das Modul des Amperemeters wird vorteilhafter Weise so ausgelegt, dass mit sehr geringem mechanischem Aufwand der Einbau, weitgehend ohne Werkzeuge, in Stromverteilerleisten möglich ist.

Der Messbereich eines derartigen Amperemeters kann beispielsweise bis 240 V bzw. 415 V und einer Stromstärke zwischen 0 bis 50 A bei ein- und/oder dreiphasiger Ausführung ausgelegt sein. Hierbei kann eine Genauigkeit über den gesamten Messbereich von etwa 0,5% erreicht werden.

Aufgrund der Auslegung im elektrischen Eingangsbereich des Ampere-Modules, insbesondere mittels elektronischer Filter, können Störungen bereits am Eingang eliminiert werden. Auf diese Weise werden auch die entsprechenden EMV-Richtlinien und Anforderungen mit einer derartigen Auslegung der Stromverteilerleiste erreicht.

Die Erfindung wird nachfolgend schematisch anhand von zwei Ausführungsbeispielen noch näher erläutert. Hierbei zeigen:
- Fig. 1: Die Draufsicht auf eine Stromverteilerleiste mit Aufbau aus mehreren Baugruppen und dem vereinfacht dargestellten Amperemeter;
- Fig. 2: eine perspektivische Darstellung eines Amperemeters in vergrößertem Maßstab; und
- Fig. 3: eine Draufsicht auf ein zweites Beispiel einer anderen Stromverteilerleiste, ebenfalls mit einem entsprechenden Amperemeter.

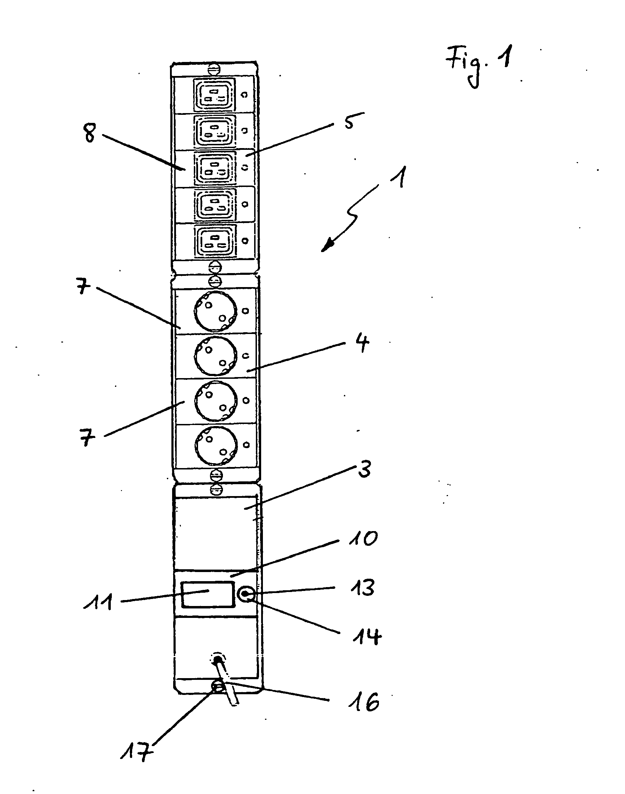

Figur 1 zeigt eine Stromverteilerleiste 1, die z.B. in vertikaler Ausrichtung in einem EDV-Schrank oder auch anderweitig zum Anschluss verschiedener Verbraucher angebracht sein kann. Im Beispiel weist die Stromverteilerleiste 1 von unter nach oben gesehen drei Baugruppen auf. Die untere Baugruppe 3 ist nach Figur 1 für ein Amperemeter 10 für die Anzeige von Echteffektivwerten des Stromes vorgesehen. Die Echteffektivwerte werden hierbei mit TRMS in der Fachbezeichnung benannt.

Die mittlere Baugruppe 4 ist nach Figur 1 z.B. als Dosenleiste mit Schuko-Standard und vier Schuko-Steckdosen 7 ausgestattet.

Die oberste Baugruppe 5 ist in der Figur 1 als Dosenleiste mit vier Kaltgerätesteckern 8 ausgelegt.

Eine Befestigungsmöglichkeit der Stromverteilerleiste 1 ist im unteren und oberen Teil über Befestigungselemente 17 angedeutet.

Über ein Kabel 16 erfolgt die Stromversorgung der im Betriebsfall an der Stromverteilerleiste 1 angeschlossenen Verteiler (nicht gezeigt). Die Auslegung der Stromverteilerleiste 1 kann hierbei einphasig oder dreiphasig sein.

Das Amperemeter 10 zeigt eine rechteckige Anzeige 11, die als LCD-Display ausgelegt ist. Zugeordnet daneben ist ein Taster 13 in einer Tastermulde 14, über den das Drehen der LCD-Anzeige . um 90°-Schritte, abhängig von der Anordnung der Stromverteilerleiste 1, oder die Änderung des Hintergrundes der Anzeige, durchgeführt werden kann.

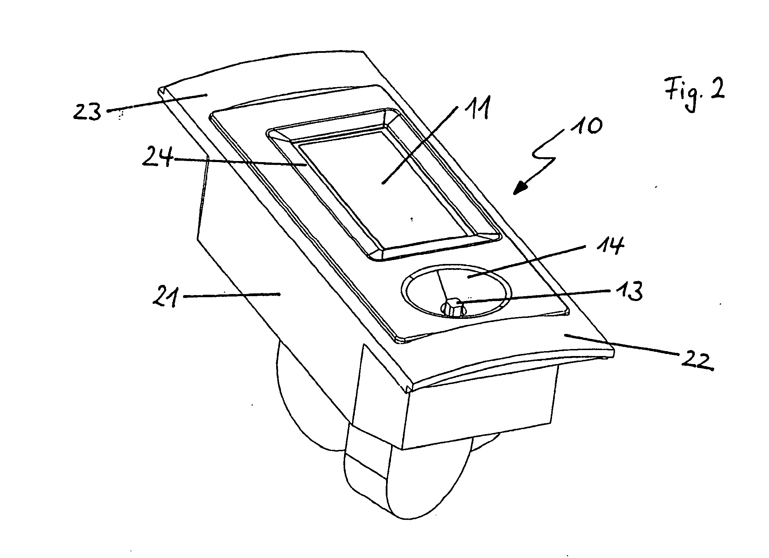

Die Darstellung nach Figur 2 zeigt in perspektivischer Ansicht ein Beispiel eines Amperemeters 10, wie es als Einzelmodul auch in anderen PDU (Power Distribution Units) vorgesehen sein kann, was in integrierter Bauweise oder auch als Einzelmodul realisierbar ist.

Das Beispiel nach Figur 2 zeigt das Amperemeter 10 mit der Anzeige 11, die vorteilhafter Weise mit einem oberen Schutzglas 24 versehen ist. Im unteren Bereich ist ein Kurzhub-Taster 13 in einer entsprechenden Tastermulde 14 vorgesehen, wodurch die Betätigung des Tasters 13 verbessert wird.

Das Gehäuse 21 des Amperemeters 10 weist im oberen Bereich eine Einbaublende 23 und im unteren Bereich eine Einbaublende 22 auf.

Unter Berücksichtigung der entsprechenden elektrischen Anschlüsse zum Stromversorgungskabel 16 kann daher das Modul des Amperemeters 10 relativ einfach in das Gehäuse einer Stromverteilerleiste eingesetzt werden.

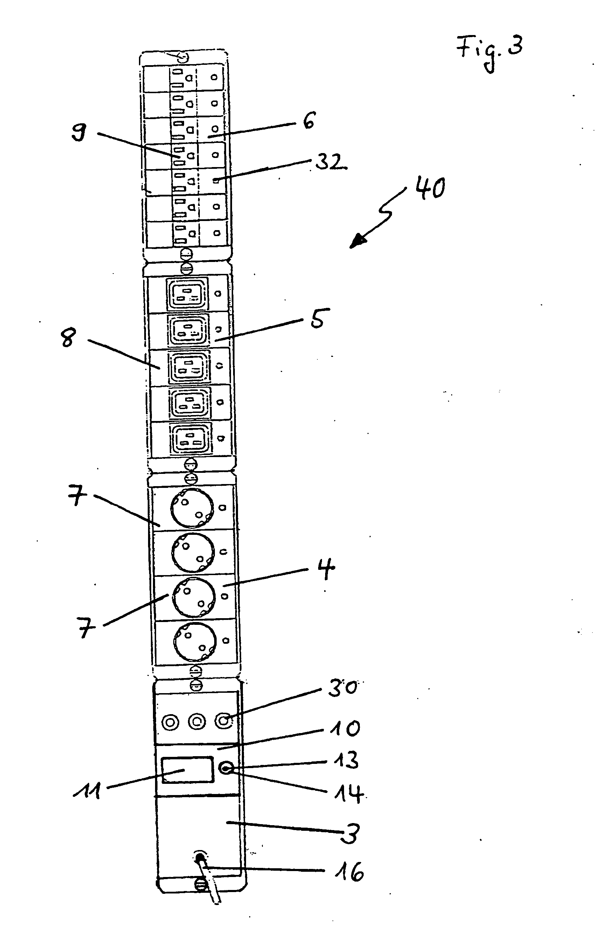

Im Beispiel nach Figur 3 ist in ähnlicher Weise wie nach Figur 1 eine Stromverteilerleiste 40 dargestellt.

Gleiche Bezugszeichen bezeichnen hierbei gleiche Elemente wie nach Figur 1.

In Figur 3 weist die Stromverteilerleiste 40, in der vertikalen Darstellung, an oberster Stelle eine weitere Baugruppe 6 auf, die z.B. dem US-Standard mit sieben Steckverbindungen 9 entspricht. Für jede Steckverbindung ist ein Anzeigeelement 32, z. B. als LED vorgesehen, so dass z.B. die Stromversorgung eines angeschlossenen Verbrauchers darüber erkennbar ist.

In der Baugruppe 3 des Amperemeters 10 sind drei Anzeigeelemente 30 für die jeweilige Phase einer dreiphasigen Stromverteilerleiste eingebaut.

Diese Anzeigeelemente 30 können z.B. bei unterschiedlicher Strombelastung der einzelnen Phasen blinken. In ähnlicher Weise ist dies auch über die Anzeige 11 des Amperemeters z.B. komplett über alle drei Phasen oder einzeln nach Umschaltung über den Taster 13 anzeigbar.

Die erfindungsgemäße Stromverteilerleiste 1 bzw. 40 ermöglicht daher eine effektive Kontrolle der von einem oder mehreren Verbrauchern gezogenen Ströme.

## Patentansprüche

1. Stromverteilerleiste
mit mindestens einem Verbraucheranschluss (7), insbesondere als Steckdose, Buchse oder Stecker, und
mit einem dem mindestens einen Verbraucheranschluss zugeordneten Amperemeter (10),
**dadurch gekennzeichnet,**
**dass** das Amperemeter (10) zur Messung und Anzeige von Echteffektivwerten (TRMS) des Stromes bei einphasiger oder dreiphasiger Ausführung ausgelegt ist, und
**dass** die Anzeige (11) des Amperemeters (10) eine Liquid-Crystal-Display-Anzeige ist und zur guten Ablesbarkeit in Winkelschritten von jeweils 90° verstellbar ist, so dass die Wertanzeige in der Liquid-Crystal-Display-Anzeige in den Winkeln 0°, 90°, 180° und 270° anzeigbar ist, und
**dass** ein Kurzhub-Taster (13), zur Verstellung der Anzeige (11) des Amperemeters (10) vorgesehen ist.

2. Stromverteilerleiste nach Anspruch 1,
**dadurch gekennzeichnet,**
**dass** das Amperemeter (10) zur Anzeige des Effektivwertes pro Phase ausgelegt ist.

3. Stromverteilerleiste nach einem der Ansprüche 1 oder 2,
**dadurch gekennzeichnet,**
**dass** die Anzeige (11) als LCD-Anzeige, insbesondere mit dunklem oder hellem Hintergrund, ausgelegt ist.

4. Stromverteilerleiste nach einem der Ansprüche 1 bis 3,
**dadurch gekennzeichnet,**
**dass** die Wahl der Phase in der Anzeige (11) komplett oder durchschaltbar wiedergebbar ist.

5. Stromverteilerleiste nach Anspruch 4,
**dadurch gekennzeichnet,**
**dass** die Phasen mittels Schalter oder Taster durchschaltbar sind.

6. Stromverteilerleiste nach einem der Ansprüche 1 bis 5,
**dadurch gekennzeichnet,**
**dass** Anzeigeelemente (30) zur Visualisierung der belasteten Phasen vorgesehen sind.

7. Stromverteilerleiste nach einem der Ansprüche 1 bis 6,
**dadurch gekennzeichnet,**
**dass** eine Einrichtung zur Erfassung und Anzeige einer Differenz der Phasenströme vorgesehen ist.

8. Stromverteilerleiste nach einem der Ansprüche 1 bis 7,
**dadurch gekennzeichnet,**
**dass** eine Überwachungseinrichtung mit Anzeige einer unterschiedlichen Belastung der Phasen bei Überschreiten eines Grenzwertes vorgesehen ist.

9. Stromverteilerleiste nach einem der Ansprüche 1 bis 8,
**dadurch gekennzeichnet,**
**dass** eine Sparschaltung zur Reduzierung der Hintergrundbeleuchtung der Anzeige (11), insbesondere nach bestimmter Zeitvorgabe vorgesehen ist.

## Claims

1. Current distribution rail,
having at least one load connector (7), in particular as a socket, female connector or plug, and
with an amperemeter (10) assigned to the at least one load connector, **characterised in that**
the amperemeter (10) is designed for measuring and displaying true effective values (TRMS) of the current for a single-phase or three-phase embodiment, and the display (11) of the amperemeter (10) is a liquid crystal display and can be adjusted for the purpose of good readability in angular stages of 90° respectively so that the value display in the liquid crystal display can be shown at the angles 0°, 90°, 180° and 270°, and
a short-travel key (13) is provided for adjusting the display (11) of the amperemeter (10).

2. Current distribution rail according to claim 1,
**characterised in that**
the amperemeter (10) is designed to display the effective value for each phase.

3. Current distribution rail according to one of claims 1 or 2,
**characterised in that**
the display (11) is configured as an LCD display, in particular with a dark or light background.

4. Current distribution rail according to one of claims 1 to 3,
**characterised in that**
the choice of phase can be reproduced in the display (11) completely or so that it can be switched through.

5. Current distribution rail according to claim 4,
**characterised in that**
the phases can be switched through by means of a switch or key.

6. Current distribution rail according to one of claims 1 to 5,
**characterised in that**
display elements (30) are provided for visualisation of the loaded phases.

7. Current distribution rail according to one of claims 1 to 6,
**characterised in that**
a means for detecting and displaying a difference of the phase currents is provided.

8. Current distribution rail according to one of claims 1 to 7,
**characterised in that**
a monitoring means with display of a different load of the phases upon exceeding a threshold value is provided.

9. Current distribution rail according to one of claims 1 to 8,
**characterised in that**
an economy circuit to reduce the background illumination of the display (11), in particular after a certain pre-specified time, is provided.

## Revendications

1. Réglette de distribution de courant
avec au moins un branchement utilisateur (7), en particulier sous forme de prise, de douille ou de fiche, et
avec un ampèremètre (10) associé audit au moins un branchement utilisateur,
***caractérisée***
***en ce que*** l'ampèremètre (10) est conçu pour mesurer et afficher des valeurs effectives réelles (TRMS) du courant dans un mode monophasé ou triphasé, et
***en ce que*** l'affichage (11) de l'ampèremètre (10) est un écran à cristaux liquides et est mobile par étapes angulaires de 90° à chaque fois, pour une bonne lisibilité, de sorte que l'affichage de valeur peut être affiché sur l'écran à cristaux liquides suivant les angles de 0°, 90°, 180° et 270°, et
*en ce qu*'une touche (13) à déplacement court est prévue pour déplacer l'affichage (11) de l'ampèremètre (10).

2. Réglette de distribution de courant selon la revendication 1,
***caractérisée en ce que*** l'ampèremètre (10) est conçu pour afficher la valeur efficace par phase.

3. Réglette de distribution de courant selon l'une quelconque des revendications 1 ou 2,
***caractérisée en ce que*** l'affichage (11) est conformé en affichage LCD, en particulier à arrière-plan foncé ou clair.

4. Réglette de distribution de courant selon l'une quelconque des revendications 1 à 3,
***caractérisée en ce que*** le choix de la phase peut être restitué sur l'affichage (11) de manière complète ou commutable.

5. Réglette de distribution de courant selon la revendication 4,
***caractérisée en ce que*** les phases sont commutables au moyen d'un commutateur ou d'une touche.

6. Réglette de distribution de courant selon l'une quelconque des revendications 1 à 5,
***caractérisée en ce que*** des éléments d'affichage (30) sont prévus pour visualiser les phases chargées.

7. Réglette de distribution de courant selon l'une quelconque des revendications 1 à 6,
*caractérisée en ce qu*'un dispositif de relevé et affichage d'une différence entre les intensités de phases est prévu.

8. Réglette de distribution de courant selon l'une quelconque des revendications 1 à 7,
*caractérisée en ce qu*'un dispositif de surveillance avec affichage d'une charge variable des phases en cas de dépassement d'une valeur limite est prévu.

9. Réglette de distribution de courant selon l'une quelconque des revendications 1 à 8,
***caractérisée en ce* qu'**un circuit économiseur est prévu pour réduire l'éclairage d'arrière-plan de l'affichage (11), en particulier après une consigne de temps prédéterminée.
